# EUROPÄISCHE PATENTSCHRIFT

(11) **EP 3 164 726 B1**
(45) Veröffentlichungstag und Bekanntmachung des Hinweises auf die Patenterteilung: **05.08.2020**
(21) Anmeldenummer: 15732674.5
(22) Anmeldetag: 29.06.2015
(51) Int. Cl.: G01R 31/333, H01H 9/00, G01R 31/327, G01R 31/62

(54) **VERFAHREN UND VORRICHTUNG ZUM PRÜFEN EINES STUFENSCHALTERS EINES TRANSFORMATORS**
METHOD AND DEVICE FOR TESTING A TAP CHANGER OF A TRANSFORMER
PROCÉDÉ ET DISPOSITIF DE CONTRÔLE D'UN COMMUTATEUR À GRADINS D'UN TRANSFORMATEUR

(30) Priorität: 02.07.2014 AT 504582014
(43) Veröffentlichungstag der Anmeldung: 10.05.2017
(73) Patentinhaber: Omicron electronics GmbH, 6833 Klaus (AT)
(72) Erfinder: RÄDLER, Michael, 6833 Klaus (AT); UNTERER, Boris, 6800 Feldkirch (AT)
(74) Vertreter: Banzer, Hans-Jörg
(86) Internationale Anmeldenummer: PCT/EP2015/064714
(87) Internationale Veröffentlichungsnummer: WO 2016/001151

(56) Entgegenhaltungen:
- EP-A1- 2 244 272
- EP-A1- 2 524 385
- GB-A- 2 158 253

## Beschreibung

Die vorliegende Erfindung betrifft ein Verfahren und eine Vorrichtung, um einen Stufenschalter eines Transformators, insbesondere eines Leistungstransformators, zu überprüfen.

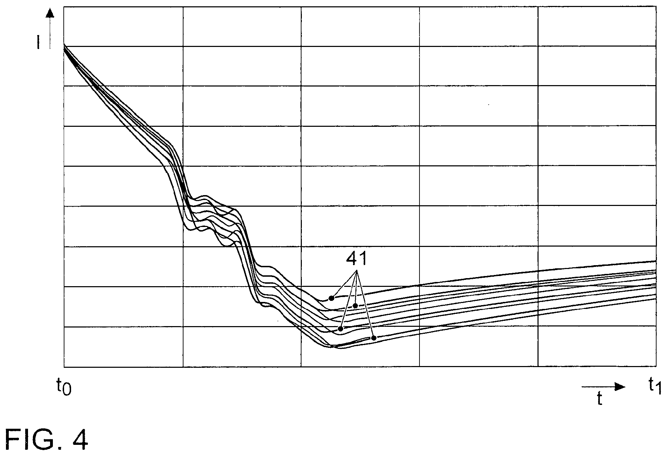

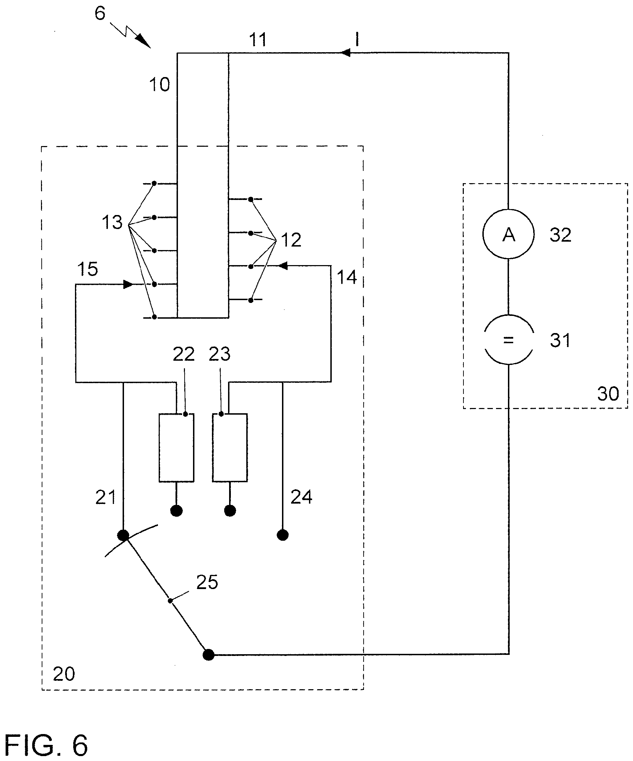

Die Druckschrift EP 2 244 272 A1 beschreibt einen Stufenschalter und ein Verfahren zum Messen einer Kontaktfolge eines Stufenschalters. In der Fig. 4 dieser Druckschrift sind Messpunkte eines bewegbaren Kontakts dargestellt, welche mit Messvorrichtungen verbunden sind. In Fig. 6 ist eine typische Schaltsequenz des Stufenschalters dargestellt, wenn von einem ersten Abgriff auf einen zweiten Abgriff des Transformators umgeschaltet wird.

Die Druckschrift EP 2 524 385 A1 betrifft die Messung der zeitlichen Reihenfolge von während der Betätigung eines Lastschalters nacheinander ablaufenden Schaltungen von Kontakt- und Schaltelementen. Dabei zeigt die Fig. 4 dieser Druckschrift ein Oszillogramm von mittels Messeinrichtungen aufgenommenen Messspannungen bei einer Lastumschaltung.

Elektrische Leistungstransformatoren, welche beispielsweise bei der Energieerzeugung, Energieübertragung, Energieverteilung oder bei Industrieanwendungen eingesetzt werden und für Leistungen größer 1 MW ausgelegt sind, umfassen häufig so genannte Stufenschalter, um das Übersetzungsverhältnis des jeweiligen Transformators beispielsweise an bestimmte Lastverhältnisse geringfügig anpassen zu können. Stufenschalter, welche auch im Betrieb des Transformators bzw. unter Last, d.h. ohne Unterbrechung des Betriebs, geschaltet werden können, werden häufig auch als Laststufenschalter ("On Load Tap Changer" (OLTC)) bezeichnet. Dazu ist die Wicklung des Transformators als eine so genannte Stufenwicklung ausgeführt, wobei Abgriffe bzw. Anzapfungen dieser Stufenwicklung an den Stufenschalter geführt sind, welcher dann im Betrieb des Transformators von einem Abgriff zu einem anderen Abgriff umschaltet, um so das Übersetzungsverhältnis des Transformators zu ändern.

Da die Wicklungen eines Transformators jeweils eine große Induktivität darstellen, ist ein Umschalten zwischen verschiedenen Übersetzungsverhältnissen nicht problemlos zu realisieren, da es nicht möglich ist, den Stromfluss durch eine Wicklung einfach zu unterbrechen. Daher ist ein Stufenschalter derart ausgestaltet, dass der Strom zu jedem Zeitpunkt durch die Wicklung fließen kann. Häufig schaltet der Stufenschalter zu diesem Zweck den Strom, welcher durch die Wicklung fließt, mit Hilfe von Widerständen um, um dadurch das Übersetzungsverhältnis zu ändern. Der Umschaltvorgang muss rasch durchgeführt werden, um eine übermäßige Erwärmung der Widerstände zu vermeiden. Aufgrund der aufwändigen und damit fehleranfälligen Mechanik der Stufenschalter ist eine regelmäßige Überprüfung jedes Stufenschalters ratsam.

Daher stellt sich die vorliegende Erfindung die Aufgabe, die Überprüfung eines Stufenschalters gegenüber dem Stand der Technik zu verbessern.

Erfindungsgemäß wird diese Aufgabe durch ein Verfahren zum Prüfen eines Stufenschalters eines Transformators nach Anspruch 1 und durch eine Vorrichtung zum Prüfen eines Stufenschalters eines Transformators nach Anspruch 9 gelöst. Die abhängigen Ansprüche definieren bevorzugte und vorteilhafte Ausführungsformen der vorliegenden Erfindung.

Im Rahmen der vorliegenden Erfindung wird ein Verfahren zum Prüfen eines Stufenschalters eines Transformators bereitgestellt. Dabei ist der Stufenschalter ausgestaltet, um (unter Last) ein Übersetzungsverhältnis des Transformators zu ändern. Das erfindungsgemäße Verfahren umfasst folgende Schritte:
- Erzeugen eines Testsignals, welches einer Wicklung des Transformators und dem Stufenschalter zugeführt wird. Bei dem Testsignal kann es sich beispielsweise um einen elektrischen Strom handeln, welcher durch die Wicklung und den in Reihe mit der Wicklung liegenden Stufenschalter fließt und typischerweise zwischen wenigen Ampere und etwa 100 Ampere stark ist. Es kann sich bei dem Testsignal auch um eine elektrische Spannung handeln, welche derart an die Wicklung und/oder den Stufenschalter angelegt wird, dass sich ein elektrischer Strom ergibt, welcher durch die Reihenschaltung aus der Wicklung und dem Stufenschalter fließt.
- Mehrfaches Betätigen des Stufenschalters, wobei bei jedem Betätigen des Stufenschalters das Übersetzungsverhältnis des Transformators geändert wird. Mit anderen Worten wird das Übersetzungsverhältnis des Transformators mehrfach geändert, indem jeweils der Stufenschalter betätigt wird.
- Erfassen eines zeitlichen Verlaufs einer elektrischen Messgröße des Transformators jeweils während der Betätigung des Stufenschalters, wobei sich die elektrische Messgröße abhängig von dem Testsignal während des Schaltvorgangs (d.h. während der Betätigung des Stufenschalters) ändert. Als die elektrische Messgröße kann beispielsweise ein durch die Wicklung und den in Reihe geschalteten Stufenschalter fließender Strom und/oder eine an der Wicklung abfallende Spannung gemessen werden, wobei sich der Strom und/oder die Spannung durch die Betätigung des Stufenschalters abhängig von dem erzeugten Testsignal ändert. Der zeitliche Verlauf der Messgröße kann beispielsweise erfasst werden, indem die Messgröße während eines vorbestimmten Zeitintervalls kontinuierlich oder zu bestimmten Zeitpunkten innerhalb dieses Zeitintervalls (z.B. 100 ms) erfasst wird. Dabei beginnt das Zeitintervall insbesondere direkt vor oder kurz nach dem Beginn der Betätigung des Stufenschalters und endet, nachdem das Übersetzungsverhältnis durch den Stufenschalter geändert wurde oder nachdem die gröbsten Änderungen der Messgröße aufgrund der Betätigung des Stufenschalters bzw. des Umschaltvorgangs abgeklungen sind.
- Zur Prüfung des Stufenschalters werden die erfassten Verläufe der Messgröße automatisch zeitlich überlagert dargestellt. Die Darstellung der Verläufe erfolgt insbesondere über eine Anzeige bzw. einen Bildschirm. Es ist allerdings auch möglich, die Verläufe zu ihrer Darstellung auf einem Drucker auszudrucken oder auf anderen Medien darzustellen. Unter der zeitlich überlagerten Darstellung der Verläufe wird dabei insbesondere verstanden, dass ein zeitliches Ende jedes der dargestellten Verläufe nach allen zeitlichen Anfängen der dargestellten Verläufe aufgetragen wird.

Anhand der zeitlich überlagerten Darstellung der Verläufe der elektrischen Messgröße kann die Entscheidung, ob der Stufenschalter korrekt arbeitet oder nicht, wesentlich besser und einfacher getroffen werden, als dies nach dem Stand der Technik der Fall ist. Dabei können die dargestellten Verläufe auch anhand historischer Daten (z.B. vorher erfassten Verläufen der Messgröße) ausgewertet werden.

Die Erfindung stellt mindestens zwei zeitliche Verläufe der Messgröße zeitlich überlagert dar. Erfindungsgemäß ist es aber auch möglich mehr als zwei (d.h. eine beliebige Anzahl) von zeitlichen Verläufen der Messgröße zeitlich überlagert darzustellen.

Das Zeitintervall, während welchem der Verlauf der jeweiligen Messgröße erfasst wird, kann so lang gewählt werden, dass der Transformator nach dem Umschalten auf das neue Übersetzungsverhältnis in die Sättigung kommt, um anhand der erfassten Messgröße auch den Widerstand der Wicklung zu bestimmen.

Gemäß einer bevorzugten erfindungsgemäßen Ausführungsform kann es sich bei dem Transformator um einen Mehrphasen-Transformator (z. B. einen Dreiphasenwechselstrom-Transformator) handeln. Bei einem Mehrphasen-Transformator ist für jede Phase des Transformators ein separater Stufenschalter vorhanden, welcher ausgestaltet ist, um (unter Last) ein Übersetzungsverhältnis des Transformators zu ändern. Zum Prüfen der Stufenschalter wird für jede Phase des Transformators gleichzeitig jeweils ein Testsignal erzeugt. Pro Phase wird dieses Testsignal einer der jeweiligen Phase zugeordneten Wicklung des Transformators und dem dieser Wicklung zugeordneten Stufenschalter zugeführt. Wenn es sich bei den Testsignalen jeweils um einen Strom handelt, wird beispielsweise für jede Phase des Transformators gleichzeitig ein Strom erzeugt, welcher durch die der jeweiligen Phase zugeordneten Wicklung und den der Wicklung zugeordneten Stufenschalter, welcher in Reihe mit der jeweiligen Wicklung liegt, fließt. Wenn es sich bei den Testsignalen jeweils um eine Spannung handelt, wird beispielsweise für jede Phase des Transformators gleichzeitig eine Spannung an die dieser Phase zugeordneten Wicklung angelegt, um dadurch einen Strom durch diese Wicklung und den zugeordneten Stufenschalter zu erzeugen. Die Stufenschalter werden mehrfach betätigt, wobei bei jedem Betätigen das Übersetzungsverhältnis geändert wird. Dabei sollten die Stufenschalter alle gleichzeitig betätigt werden. Während der Betätigung der Stufenschalter wird für jeden Stufenschalter ein zeitlicher Verlauf der elektrischen Messgröße, welche sich abhängig von dem Testsignal während des Schaltvorgangs ändert, erfasst. Bei dieser Messgröße kann es sich um einen elektrischen Strom handeln, welcher durch eine der Wicklungen und den dieser Wicklung zugeordneten in Reihe mit dieser Wicklung liegenden Stufenschalter fließt. Es ist allerdings auch möglich, dass es sich bei der Messgröße um eine elektrische Spannung handelt, welche an einer der Wicklungen abfällt. Die Verläufe des jeweiligen Stufenschalters werden zeitlich überlagert automatisch dargestellt. Dabei können auch Verläufe der Messgröße von verschiedenen Phasen und/oder derselben Phase zeitlich überlagert dargestellt werden.

Insbesondere anhand der zeitlich überlagerten Darstellung von Verläufen der Messgröße von verschiedenen Phasen können vorteilhafterweise auftretende Amplitudensprünge oder zeitliche Verschiebungen für die verschiedenen Phasen verglichen werden, um anhand dieses Vergleichs zu entscheiden, ob die Stufenschalter des Mehrphasen-Transformators korrekt arbeiten.

Die Testsignale können für jede Phase so erzeugt werden, dass die Testsignale denselben Betrag aufweisen, wodurch die aufgezeichneten Verläufe direkt miteinander vergleichbar sind.

Bei einem dreiphasigen Transformator mit Sternpunktanschluss, welcher vorzugsweise eine Y- oder eine Z-Wicklung aufweist, können alle drei Phasen gleichzeitig geprüft werden. Dazu kann als Testsignal ein Strom eingeprägt werden, welcher bei zwei Phasen in die Wicklung hinein (d.h. bei dem dem Sternpunkt abgewandten Ende der Wicklung eingeprägt wird) und bei einer Phase hinaus (d.h. an dem dem Sternpunkt abgewandten Ende von der Wicklung abgezogen wird) fließt. Wenn die drei Ströme vom Betrag her gleich sind, fließt zusätzlich noch ein vierter Strom hinaus (d.h. er wird an dem dem Sternpunkt abgewandten Ende von der Wicklung abgezogen).

Sowohl bei einem Mehrphasen-Transformator als auch bei einem einphasigen Transformator kann es sich bei dem Testsignal um ein Gleichstromsignal, d.h. um einen elektrischen Gleichstrom, handeln.

Bei der zeitlich überlagerten Darstellung der Verläufe der jeweils erfassten elektrischen Messgröße gibt es zum einen die Möglichkeit, die Verläufe möglichst deckungsgleich aufzutragen, so dass beispielsweise zwei identische Verläufe genau übereinander dargestellt werden. Eine andere erfindungsgemäße Möglichkeit besteht darin, die Verläufe (leicht) versetzt aufzutragen, so dass beispielsweise zwei identische Verläufe unterschieden werden können. Dabei können die Verläufe entweder in Richtung der Zeitachse und/oder senkrecht zu der Zeitachse versetzt dargestellt werden.

Zur zeitlich überlagerten Darstellung der Verläufe werden insbesondere einander entsprechende Zeitabschnitte der Verläufe zeitlich überlagert dargestellt.

Wie bereits vorab beschrieben ist, kann der jeweils entsprechende Zeitabschnitt bzw. das jeweils entsprechende Zeitintervall des jeweiligen Verlaufs kurz vor oder kurz nach der jeweiligen Betätigung des Stufenschalters beginnen und nach dem Ende der Durchführung der Umschaltung auf ein neues Übersetzungsverhältnis enden. Der jeweilige Zeitabschnitt des jeweiligen Verlaufs kann beispielsweise 100 ms des jeweiligen Umschaltvorgangs betragen.

Wie ebenfalls zumindest teilweise vorab beschrieben ist, kann die elektrische Messgröße eine oder mehrere der folgenden elektrischen Messgrößen umfassen:
- Den elektrischen Strom, welcher durch die jeweilige Wicklung und den dieser Wicklung zugeordneten Stufenschalter fließt.
- Die elektrische Spannung, welche an der jeweiligen Wicklung abfällt.
- Einen elektrischen Widerstandswert, welcher abhängig von der Spannung und dem Strom (insbesondere als Quotient aus der Spannung und dem Strom) berechnet wird. Bei diesem Widerstandswert kann es sich um einen ohmschen Widerstandswert bzw. Gleichstromwiderstandswert oder um einen Impedanzwert bzw. Wechselstromwiderstand handeln.

Erfindungsgemäß kann es sich bei der Messgröße auch um andere elektrische Größen, wie z.B. die elektrische Leistung oder die elektrische Energie, welche von der jeweiligen Wicklung aufgenommen oder von dieser abgegeben wird, handeln.

Im Rahmen der vorliegenden Erfindung wird auch eine Vorrichtung zum Prüfen eines Stufenschalters eines Transformators bereitgestellt. Dabei ist der Stufenschalter ausgestaltet, um (unter Last bzw. im Betrieb) ein Übersetzungsverhältnis des Transformators zu ändern. Die Vorrichtung umfasst Testsignalerzeugungsmittel, Messmittel und Steuermittel. Mit Hilfe der Testsignalerzeugungsmittel und der Steuermittel erzeugt die Vorrichtung ein Testsignal, welches einer Wicklung des Transformators und dem Stufenschalter zugeführt wird. Mit Hilfe der Messmittel ist die Vorrichtung in der Lage, einen zeitlichen Verlauf einer elektrischen Messgröße des Transformators jeweils während einer Betätigung des Stufenschalters in Abhängigkeit von dem Testsignal zu erfassen.

Die Steuermittel sind ausgestaltet, um die Verläufe zeitlich überlagert darzustellen.

Die Vorteile der erfindungsgemäßen Vorrichtung entsprechen im Wesentlichen den Vorteilen des erfindungsgemäßen Verfahrens, welche vorab im Detail ausgeführt sind, so dass hier auf eine Wiederholung verzichtet wird.

Gemäß einer erfindungsgemäßen Ausführungsform kann es sich bei dem Transformator um einen Mehrphasen-Transformator handeln, wobei für jede Phase des Transformators ein separater Stufenschalter vorhanden ist, welcher ausgestaltet ist, um (unter Last) ein Übersetzungsverhältnis des Transformators zu ändern. Gemäß dieser erfindungsgemäßen Ausführungsform ist die Vorrichtung somit zum Prüfen eines bzw. der Stufenschalter eines Mehrphasen-Transformators ausgestaltet. Darüber hinaus ist die Vorrichtung ausgestaltet, um mit Hilfe der Testsignalerzeugungsmittel gleichzeitig jeweils ein Testsignal für jede Phase des Transformators zu erzeugen und um diese Testsignale jeweils (d.h. jeweils eines dieser Testsignale) einer der jeweiligen Phase zugeordneten Wicklung des Transformators und dem dieser Wicklung zugeordneten Stufenschalter zuzuführen. Die Vorrichtung ist in der Lage, um mit Hilfe der Messmittel für jeden Stufenschalter einen zeitlichen Verlauf einer elektrischen Messgröße des Transformators jeweils während einer Betätigung der Stufenschalter zu erfassen. Mit Hilfe der Steuermittel stellt die erfindungsgemäße Vorrichtung für jeden Stufenschalter die Verläufe des jeweiligen Stufenschalters zeitlich überlagert dar.

Die Vorteile dieser erfindungsgemäßen Ausführungsform entsprechen im Wesentlichen den Vorteilen der entsprechenden Ausführungsform des erfindungsgemäßen Verfahrens, welche vorab im Detail ausgeführt sind, so dass hier auf eine Wiederholung verzichtet wird.

Die Vorrichtung umfasst insbesondere eine Anzeige und ist derart ausgestaltet, dass die Vorrichtung mit Hilfe der Steuermittel die Verläufe auf dieser Anzeige darstellt.

Durch die grafische Darstellung der zeitlich überlagerten Verläufe der elektrischen Messgröße für den jeweiligen Stufenschalter wird die Interpretation der erfassten Messgrößen im Vergleich zum Stand der Technik vereinfacht. Dadurch wird letztlich auch die Prüfung des Stufenschalters vereinfacht.

Die vorliegende Erfindung kann insbesondere zur Prüfung von Stufenschaltern von Leistungstransformatoren eingesetzt werden. Selbstverständlich ist die vorliegende Erfindung nicht auf diesen bevorzugten Anwendungsbereich eingeschränkt, da die Erfindung beispielsweise auch zur Prüfung von Stufenschaltern von Transformatoren, welche nicht als Leistungstransformatoren gelten, eingesetzt werden kann.

Im Folgenden wird die vorliegende Erfindung anhand bevorzugter erfindungsgemäßer Ausführungsformen mit Bezug zu den Figuren im Detail beschrieben.

In Fig. 1 sind mehrere zeitliche Verläufe eines elektrischen Stroms beim Betätigen eines Stufenschalters eines Transformators erfindungsgemäß dargestellt.

In Figuren 2-4 sind nur bestimmte der in Fig. 1 dargestellten zeitlichen Verläufe dargestellt.

In Fig. 5 sind die zeitlichen Verläufe eines elektrischen Stroms beim Betätigen eines Stufenschalters eines Transformators nicht zeitlich überlagert, sondern zeitlich hintereinander dargestellt.

In Fig. 6 ist ein Transformator mit Stufenschalter zusammen mit einer erfindungsgemäßen Vorrichtung dargestellt.

In Fig. 7 ist ein Mehrphasen-Transformator zusammen mit einer erfindungsgemäßen Vorrichtung dargestellt.

In Fig. 8 ist schematisch eine erfindungsgemäße Vorrichtung dargestellt.

Obwohl in den folgenden Figuren beispielhaft sowohl als Testsignal als auch als Messgröße jeweils ein elektrischer Strom dargestellt ist, sei explizit darauf hingewiesen, dass erfindungsgemäß als Testsignal auch eine Spannung angelegt werden kann und/oder dass als Messgröße auch eine Spannung, ein elektrischer Widerstand, eine Impedanz, eine Leistung, eine Energie usw. eingesetzt bzw. erfasst werden kann.

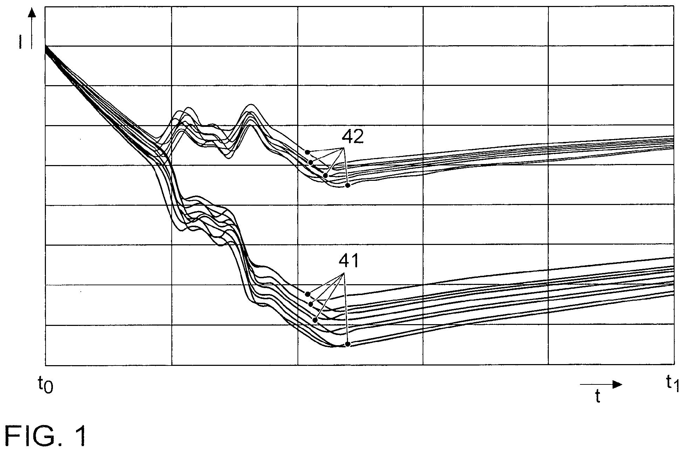

In Fig. 1 sind mehrere zeitliche Verläufe 41, 42 eines elektrischen Stroms erfindungsgemäß zeitlich überlagert dargestellt, wobei jeder der Verläufe 41, 42 bei der Betätigung eines Stufenschalters eines Transformators erfasst wird. Der elektrische Strom, dessen Verlauf erfasst wird, fließt dabei durch die Wicklung und den in Reihe mit der Wicklung liegenden Stufenschalter. Für jeden der Verläufe wird jeweils ein Zeitabschnitt dargestellt, welcher bei einem ersten Zeitpunkt t₀ beginnt und bei einem zweiten Zeitpunkt t₁ endet. Dabei liegt der erste Zeitpunkt t₀ kurz nach Beginn der Betätigung des Stufenschalters und der zweite Zeitpunkt t₁ liegt zeitlich nach dem Ende des Umschaltvorgangs des Stufenschalters.

Im vorliegenden Fall weist die Wicklung elf Abgriffe oder Anzapfungen auf, zwischen welchen der Stufenschalter umschalten kann, wie es genauer mit Fig. 6 erläutert wird. Die mit dem Bezugszeichen 41 gekennzeichneten Verläufe zeigen jeweils einen von zehn Stromverläufen, welche erfasst werden, wenn der Stufenschalter aufwärts schaltet, wodurch sich die Anzahl der effektiven Windungen der Wicklung verringert. In ähnlicher Weise zeigen die mit dem Bezugszeichen 42 gekennzeichneten Verläufe jeweils einen von zehn Stromverläufen, welche erfasst werden, wenn der Stufenschalter abwärts schaltet, wodurch sich die Anzahl der effektiven Windungen der Wicklung vergrößert.

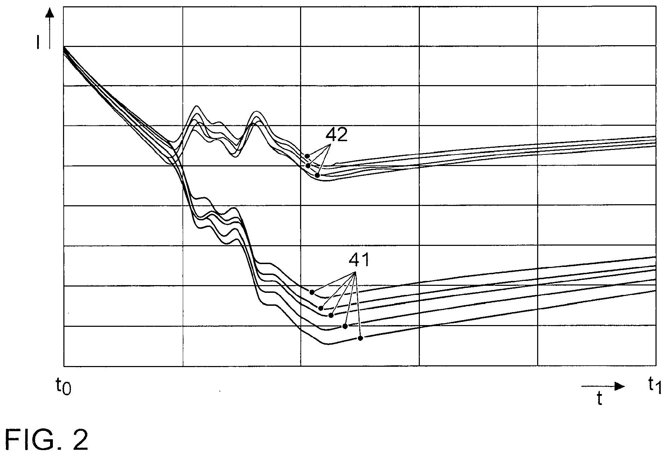

Wie in Fig. 6 dargestellt ist, existieren linksseitige oder ungeradzahlige Abgriffe 13 und rechtsseitige oder geradzahlige Abgriffe 12 der Wicklung 10. In Fig. 2 sind nur die Stromverläufe 41, 42 bei geradzahligen Schaltvorgängen dargestellt, indem die Stromverläufe bei ungeradzahligen Schaltvorgängen mittels Filtern unterdrückt werden. Ein geradzahliger Schaltvorgang liegt dabei dann vor, wenn auf einen geradzahligen oder rechtsseitigen Abgriff 12 umgeschaltet wird. Dabei kann sowohl bei einem Abwärtsschalten als auch bei einem Aufwärtsschalten auf einen geradzahligen oder rechtsseitigen Abgriff 12 umgeschaltet werden. Mit anderen Worten zeigen die mit dem Bezugszeichen 41 in Fig. 2 gekennzeichneten Stromverläufe fünf geradzahlige Schaltvorgänge beim Abwärtsschalten, während die mit dem Bezugszeichen 42 in Fig. 2 gekennzeichneten Stromverläufe fünf geradzahlige Schaltvorgänge beim Aufwärtsschalten darstellen.

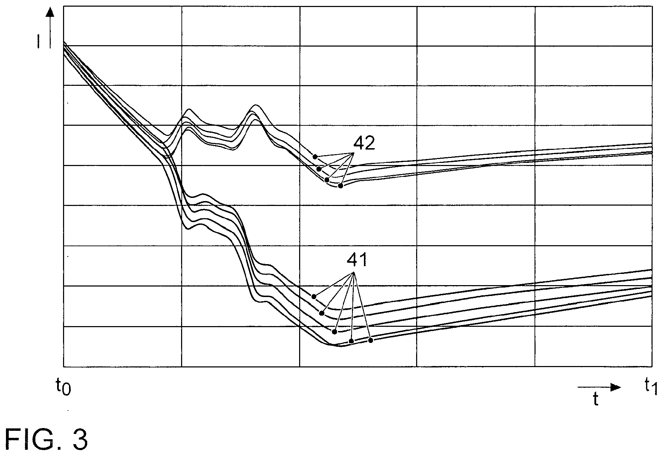

Dagegen sind in Fig. 3 nur die Stromverläufe 41, 42 bei ungeradzahligen Schaltvorgängen dargestellt, indem die Stromverläufe bei geradzahligen Schaltvorgängen mittels Filtern unterdrückt werden. Ein ungeradzahliger Schaltvorgang liegt dann vor, wenn auf einen ungeradzahligen oder linksseitigen Abgriff 13 (siehe Fig. 6) umgeschaltet wird. Wie bei den geradzahligen Schaltvorgängen, kann bei den ungeradzahligen Schaltvorgängen sowohl bei einem Abwärtsschalten als auch bei einem Aufwärtsschalten auf einen ungeradzahligen oder linksseitigen Abgriff 13 umgeschaltet werden. Anders ausgedrückt zeigen die mit dem Bezugszeichen 41 in Fig. 3 gekennzeichneten Stromverläufe fünf ungeradzahlige Schaltvorgänge beim Abwärtsschalten, während die mit dem Bezugszeichen 42 in Fig. 3 gekennzeichneten Stromverläufe fünf ungeradzahlige Schaltvorgänge beim Aufwärtsschalten darstellen.

In Fig. 4 sind nur die zehn Stromverläufe 41 bei geradzahligen Schaltvorgängen dargestellt, so dass die zehn Stromverläufe 42 bei ungeradzahligen Schaltvorgängen (siehe Fig. 1) nicht dargestellt sind, da sie herausgefiltert wurden.

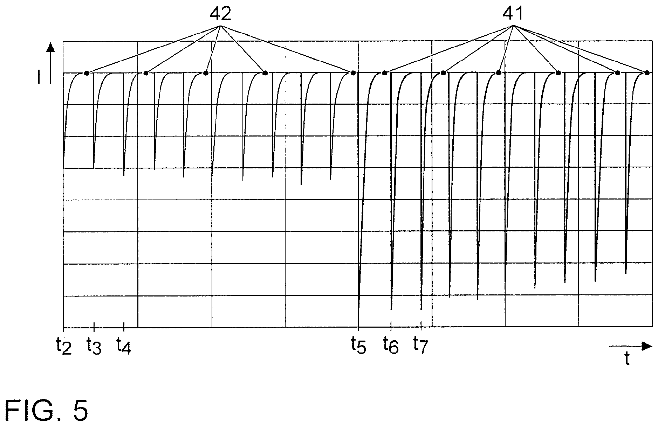

In Fig. 5 sind die 20 Stromverläufe 41, 42 aus Fig. 1 zeitlich nebeneinander dargestellt. Dabei entspricht ein Zeitpunkt (z.B. t₃ oder t₆), zu welchem ein Stromverlauf 41, 42 endet, einem Zeitpunkt, zu welchem ein benachbart dazu dargestellter Stromverlauf beginnt. Mit anderen Worten sind die in Fig. 5 dargestellten Stromverläufe nicht zeitlich überlagert dargestellt.

In Fig. 6 sind ein Transformator 6 mit einem Stufenschalter 20 und eine erfindungsgemäße Vorrichtung 30 zum Prüfen des Stufenschalters 20 dargestellt.

Der Transformator 6 umfasst eine Wicklung 10, welche mehrere Abgriffe oder Anzapfungen 12, 13 aufweist. Der Stufenschalter 20 umfasst zwei Stufenwähler 14, 15. Dabei ist der eine Stufenwähler 14 mit einem der rechtsseitigen oder geradzahligen Abgriffe 12 und der andere Stufenwähler 15 mit einem der linksseitigen oder ungeradzahligen Abgriffe 13 verbunden. Darüber hinaus umfasst der Stufenschalter 20 einen ersten Anschluss 21 und einen ersten Widerstand 22, welche dem Stufenwähler 15 zugeordnet sind, sowie einen zweiten Anschluss 24 und einen zweiten Widerstand 23, welche dem Stufenwähler 14 zugeordnet sind. Bei dem in Fig. 6 dargestellten Zustand fließt ein Strom I bei Anschluss 11 in die Wicklung 10 hinein und bei dem Abgriff 13, welcher mit dem Stufenwähler 15 in Kontakt steht, aus der Wicklung 10 heraus.

Um nun das Übersetzungsverhältnis des Transformators 6 zu ändern, wird ein Umschalter 25 des Stufenschalters 20 vom Anschluss 21 zum Anschluss 24 geschaltet. Dabei kontaktiert der Umschalter 25 in einem ersten Schritt sowohl den ersten Anschluss 21 als auch den ersten Widerstand 22, so dass der Strom I durch den ersten Widerstand 22 fließt, wenn der Umschalter 25 im zweiten Schritt den Kontakt zum ersten Anschluss 21 verliert. Im dritten Schritt kontaktiert der Umschalter 25 sowohl den ersten Widerstand 22 als auch den zweiten Widerstand 23, so dass der Strom I sowohl über den ersten Widerstand 22 als auch über den zweiten Widerstand 23 und damit sowohl über den Stufenwähler 15 und den entsprechenden Abgriff 13 als auch über den Stufenwähler 14 und den entsprechenden Abgriffe 12 fließt. Wenn der Umschalter 25 weiter geschaltet wird, verliert der Umschalter 25 im vierten Schritt den Kontakt mit dem ersten Widerstand 22, so dass der Strom I im vierten Schritt nur über den zweiten Widerstand 23 und den Stufenwähler 14 und den entsprechenden Abgriff 12 fließt. Wenn der Umschalter 25 weiter geschaltet wird, kontaktiert der Umschalter 25 im fünften Schritt den zweiten Anschluss 24, so dass der zweite Widerstand 23 quasi kurzgeschlossen wird. Der Strom I fließt über den zweiten Anschluss 24 sowie den Stufenwähler 14 und den zugehörigen Abgriff 12, so dass sich das Übersetzungsverhältnis des Transformators 6 entsprechend ändert. Wenn der Umschalter 25 weiter geschaltet wird, verliert der Umschalter 25 im sechsten und letzten Schritt den Kontakt zum zweiten Widerstand 23, womit der Umschaltvorgang oder die Betätigung des Stufenschalters 20 zur Änderung des Übersetzungsverhältnisses des Transformators 6 endgültig beendet ist.

Sobald der Stufenwähler 15 stromlos geschaltet ist (also mit dem vierten Schritt), kann der Stufenwähler mit einem anderen linksseitigen oder ungeradzahligen Abgriff 13 verbunden werden. Um das Übersetzungsverhältnis des Transformators 6 erneut zu ändern, wird der Umschalter 25 in ähnlicher Weise, wie vorab beschrieben, von dem zweiten Anschluss 24 zu dem ersten Anschluss 21 geschaltet.

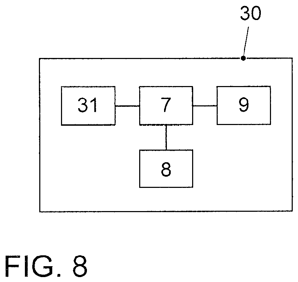

Zur Prüfung oder zum Test des Stufenschalters 20 existiert die erfindungsgemäße Vorrichtung 30, welche eine Stromquelle 31 und einen Strommesser 32 umfasst. Mit Hilfe der Stromquelle 31 wird der Strom I erzeugt, welcher durch die Wicklung 10 und den in Reihe mit der Wicklung 10 liegenden Stufenschalter 20 fließt. Insbesondere ein zeitlicher Verlauf des durch die Wicklung 10 und den Stufenschalter 20 fließenden Stroms I wird während des Umschaltens des Stufenschalters 20 mit einer entsprechenden Messeinrichtung 9 (siehe Fig. 8) der erfindungsgemäßen Vorrichtung 30 erfasst und zusammen mit anderen Stromverläufen, welche während anderer Umschaltvorgänge des Stufenschalters 20 erfasst wurden, zeitlich überlagert dargestellt.

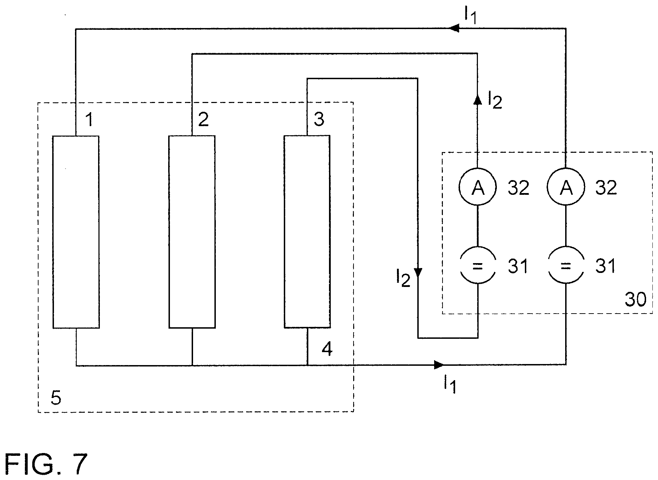

In Fig. 7 ist ein Mehrphasen-Transformator 5 dargestellt, welcher drei Phasen mit jeweils einer Wicklung 1-3 in Y-Verschaltung umfasst. Dabei weist jede Phase bzw. Wicklung 1-3 einen Stufenschalter 20 (in Fig. 7 nicht dargestellt) auf, um das Übersetzungsverhältnis des Transformators 5 in derselben Weise zu ändern, wie es vorab bezüglich Fig. 6 beschrieben ist.

Zur Prüfung der Stufenschalter erzeugt die erfindungsgemäße Vorrichtung 30 einen ersten Gleichstrom I₁, welcher dem dem Sternpunkt 4 abgewandten Ende der ersten Wicklung 1 zugeführt wird, und einen zweiten Gleichstrom l₂, welcher zum einen von dem dem Sternpunkt 4 abgewandten Ende der dritten Wicklung 3 abgezogen und zum anderen dem dem Sternpunkt 4 abgewandten Ende der zweiten Wicklung 2 zugeführt wird. Man erkennt, dass der erste Gleichstrom I₁ auch von dem Sternpunkt 4 zu der Vorrichtung 30 abfließt. Mit anderen Worten weisen die Testsignale bzw. Gleichströme I₁, I₂, welche jeder Wicklung 1-3 zugeführt werden, denselben Betrag auf.

Die zeitlichen Verläufe der Ströme durch die drei Wicklungen 1-3 werden erfasst, während die Stufenschalter mehrfach geschaltet werden, um das Übersetzungsverhältnis des Mehrphasen-Transformators 5 zu ändern. Pro Stufenschalter werden mehrere der erfassten Stromverläufe zeitlich überlagert dargestellt, um den korrekten Betrieb der Stufenschalter zu überprüfen.

In Fig. 8 ist schematisch eine weitere Ausführungsform der erfindungsgemäßen Vorrichtung 30 dargestellt. Die Vorrichtung 30 umfasst neben einer Stromquelle 31, welche den Testsignalerzeugungsmitteln entspricht, eine Steuerung 7, eine Anzeige 8 und Messmittel 9, mit welchen ein zeitlicher Verlauf 41, 42 der elektrischen Messgröße erfasst werden kann. Auf der Anzeige 8 werden die erfassten zeitlichen Verläufe 41, 42 zeitlich überlagert dargestellt.

### BEZUGSZEICHENLISTE

- 1-3: Wicklung
- 4: Sternpunkt
- 5: Dreiphasenwechselstrom-Transformator
- 6: Transformator
- 7: Steuerung
- 8: Anzeige
- 9: Messeinrichtung
- 10: Wicklung
- 12, 13: Abgriff bzw. Anzapfung
- 14, 15: Stufenwähler
- 20: Stufenschalter
- 11,21,24: Anschluss
- 22, 23: Widerstand
- 25: Umschalter
- 30: Vorrichtung
- 31: Stromquelle
- 32: Strommesser
- 41: Stromverlauf bei Abwärtsschalten
- 42: Stromverlauf bei Aufwärtsschalten
- I, I₁, I₂: Gleichstrom
- t: Zeit
- tₓ: Zeitpunkt

## Patentansprüche

1. Verfahren zum Prüfen eines Stufenschalters (20) eines Transformators (5; 6),
wobei der Stufenschalter (20) ausgestaltet ist, um ein Übersetzungsverhältnis des Transformators (5; 6) zu ändern,
wobei das Verfahren folgende Schritte umfasst:
Erzeugen eines Testsignals, welches einer Wicklung (1-3; 10) des Transformators (5; 6) und dem Stufenschalter (20) zugeführt wird,
mehrfaches Betätigen des Stufenschalters (20), um bei jedem Betätigen das Übersetzungsverhältnis zu ändern,
Erfassen eines Verlaufs einer elektrischen Messgröße (I; I₁; I₂) des Transformators (5; 6) über der Zeit (t) jeweils während des Schritts des Betätigens des Stufenschalters (20) abhängig von dem Testsignal, und
automatisches zeitlich überlagertes Darstellen der während des mehrfachen Betätigens des Stufenschalters (20) erfassten Verläufe (41, 42) der elektrischen Messgröße (I; I₁; I₂).

2. Verfahren nach Anspruch 1,
**dadurch gekennzeichnet,**
**dass** der Transformator ein Mehrphasen-Transformator (5) ist,
**dass** für jede Phase des Transformators (5) ein separater Stufenschalter (20) vorhanden ist, welcher ausgestaltet ist, um ein Übersetzungsverhältnis des Transformators (5) zu ändern,
**dass** gleichzeitig jeweils ein Testsignal für jede Phase des Transformators (5) erzeugt wird, welches einer der jeweiligen Phase zugeordneten Wicklung (1-3) des Transformators (5) und dem der Wicklung (1-3) zugeordneten Stufenschalter (20) zugeführt wird,
**dass** mehrfach die Stufenschalter (20) betätigt werden, um bei jedem Betätigen das Übersetzungsverhältnis zu ändern,
**dass** ein Verlauf einer elektrischen Messgröße (I₁; I₂) des Transformators (5) über der Zeit (t) jeweils während des Schritts des Betätigens der Stufenschalter (20) für jeden Stufenschalter (20) abhängig von dem Testsignal erfasst wird, und
**dass** die Verläufe (41, 42) des jeweiligen Stufenschalters (20) automatisch zeitlich überlagert dargestellt werden.

3. Verfahren nach Anspruch 2,
**dadurch gekennzeichnet,**
**dass** die Testsignale für jede Phase vom Betrag her gleich erzeugt werden.

4. Verfahren nach einem der vorhergehenden Ansprüche,
**dadurch gekennzeichnet,**
**dass** das Testsignal ein Gleichstromsignal ist.

5. Verfahren nach einem der vorhergehenden Ansprüche,
**dadurch gekennzeichnet,**
**dass** die Verläufe (41, 42) möglichst deckungsgleich aufgetragen werden.

6. Verfahren nach einem der Ansprüche 1-4,
**dadurch gekennzeichnet,**
**dass** die Verläufe versetzt aufgetragen werden.

7. Verfahren nach einem der vorhergehenden Ansprüche,
**dadurch gekennzeichnet,**
**dass** einander entsprechende Zeitabschnitte (t₀-t₁) der Verläufe (41, 42) zeitlich überlagert dargestellt werden.

8. Verfahren nach einem der vorhergehenden Ansprüche,
**dadurch gekennzeichnet,**
**dass** die elektrische Messgröße
einen Strom (I; I₁; I₂), welcher durch die Wicklung (1-3; 10) und den Stufenschalter (20) fließt,
eine Spannung, welche an der Wicklung (1-3; 10) abfällt, oder
einen elektrischen Widerstandswert, welcher abhängig von der Spannung und dem Strom (I; I₁; I₂) berechenbar ist,
umfasst.

9. Vorrichtung zum Prüfen eines Stufenschalters (20) eines Transformators (5; 6),
wobei der Stufenschalter (20) ausgestaltet ist, um ein Übersetzungsverhältnis des Transformators (5; 6) zu ändern,
wobei die Vorrichtung (30) Testsignalerzeugungsmittel (31), Messmittel (9) und Steuermittel (7) umfasst,
wobei die Vorrichtung (30) ausgestaltet ist, um mittels der Testsignalerzeugungsmittel (31) und der Steuermittel (7) ein Testsignal einer Wicklung (10) des Transformators (5; 6) und dem Stufenschalter (20) zuzuführen,
wobei die Vorrichtung (30) ausgestaltet ist, um mittels der Messmittel (9) einen Verlauf einer elektrischen Messgröße (I; I₁; I₂) des Transformators (5; 6) über der Zeit (t) jeweils während eines Betätigens des Stufenschalters (20) abhängig von dem Testsignal zu erfassen, und
wobei die Steuermittel (7) ausgestaltet sind, um die während des mehrfachen Betätigens des Stufenschalters (20) erfassten Verläufe (41, 42) der elektrischen Messgröße (I; I₁; I₂) zeitlich überlagert darzustellen.

10. Vorrichtung nach Anspruch 9,
**dadurch gekennzeichnet,**
**dass** der Transformator ein Mehrphasen-Transformator (5) ist,
**dass** für jede Phase des Transformators (5) ein separater Stufenschalter (20) vorhanden ist, welcher ausgestaltet ist, um ein Übersetzungsverhältnis des Transformators (5) zu ändern,
**dass** die Vorrichtung (30) ausgestaltet ist, um mittels der Testsignalerzeugungsmittel (31) gleichzeitig jeweils ein Testsignal für jede Phase des Transformators (5) zu erzeugen und einer der jeweiligen Phase zugeordneten Wicklung (1-3) des Transformators (5) und dem der Wicklung (1-3) zugeordneten Stufenschalter (20) zuzuführen,
**dass** die Vorrichtung (30) ausgestaltet ist, um mittels der Messmittel (9) einen Verlauf einer elektrischen Messgröße (I₁; I₂) des Transformators (5) über der Zeit (t) jeweils während eines Betätigens der Stufenschalter (20) für jeden Stufenschalter (20) abhängig von dem Testsignal zu erfassen, und
**dass** die Steuermittel (7) ausgestaltet sind, um pro Stufenschalter (20) die Verläufe (41, 42) des jeweiligen Stufenschalters (20) zeitlich überlagert darzustellen.

11. Vorrichtung nach Anspruch 9 oder 10,
**dadurch gekennzeichnet,**
**dass** die Vorrichtung (30) eine Anzeige (8) umfasst,
**dass** die Vorrichtung (30) ausgestaltet ist, dass die Steuermittel (7) die Verläufe (41, 42) auf der Anzeige (8) darstellen.

12. Vorrichtung nach einem der Ansprüche 9-11,
**dadurch gekennzeichnet,**
**dass** die Vorrichtung (30) zur Durchführung des Verfahrens nach einem der Ansprüche 1-8 ausgestaltet ist.

## Claims

1. Method for testing a tap changer (20) of a transformer (5; 6),
wherein the tap changer (20) is configured to change a transmission ratio of the transformer (5; 6),
wherein the method comprises the following steps:
generating a test signal which is supplied to a winding (1-3; 10) of the transformer (5; 6) and to the tap changer (20),
repeatedly actuating the tap changer (20) in order to change the transmission ratio with each actuation,
detecting a curve of an electrical measurement variable (I; I₁; I₂) of the transformer (5; 6) over time (t) respectively during the step of actuating the tap changer (20) depending on the test signal, and
automatically illustrating the curves (41, 42) of the electrical measurement variable (I; I₁; I₂) detected during the repeatedly actuating of the tap changer (20) in a temporally-superimposed manner.

2. Method according to claim 1,
**characterised in that**
the transformer is a multi-phase transformer (5),
a separate tap changer (20) is provided for each phase of the transformer (5) which is configured to change a transmission ratio of the transformer (5),
respectively one test signal is generated simultaneously for each phase of the transformer (5) which is supplied to a winding (1-3) of the transformer (5) assigned to the respective phase and to the tap changer (20) assigned to the winding (1-3),
the tap changers (20) are actuated repeatedly in order to change the transmission ratio with each actuation,
a curve of an electrical measurement variable (I₁; I₂) of the transformer (5) is detected over time (t) respectively during the step of actuating the tap changers (20) for each tap changer (20) depending on the test signal, and the curves (41, 42) of the respective tap changer (20) are automatically illustrated in a temporally-superimposed manner.

3. Method according to claim 2,
**characterised in that**
the test signals for each phase are generated identically in terms of value.

4. Method according to any one of the preceding claims,
**characterised in that**
the test signal is a direct current signal.

5. Method according to any one of the preceding claims,
**characterised in that**
the curves (41, 42) are plotted as congruently as possible.

6. Method according to any one of claims 1-4,
**characterised in that**
the curves are plotted in an offset manner.

7. Method according to any one of the preceding claims,
**characterised in that**
time periods (to-ti) of the curves (41, 42) corresponding to each other are illustrated in a temporally-superimposed manner.

8. Method according to any one of the preceding claims,
**characterised in that**
the electrical measurement variable comprises
a current (I; I₁; I₂) which flows through the winding (1-3; 10) and the tap changer (20),
a voltage drop at the winding (1-3; 10), or
an electrical resistance value which can be calculated depending on the voltage and the current (I; I₁; I₂).

9. Device for testing a tap changer (20) of a transformer (5; 6),
wherein the tap changer (20) is configured to change a transmission ratio of the transformer (5; 6),
wherein the device (30) comprises test signal generation means (31), measuring means (9) and control means (7),
wherein the device (30) is configured to supply a test signal to a winding (10) of the transformer (5; 6) and to the tap changer (20) by means of the test signal generation means (31) and the control means (7),
wherein the device (30) is configured to determine a curve of an electrical measurement variable (I; I₁; I₂) of the transformer (5; 6) by means of the measuring means (9) over time (t) respectively during an actuation of the tap changer (20) depending on the test signal, and
wherein the control means (7) are configured to illustrate the curves (41, 42) of the electrical measurement variable (I; I₁; I₂) detected during the repeated actuation of the tap changer (20) in a temporally-superimposed manner.

10. Device according to claim 9,
**characterised in that**
the transformer is a multi-phase transformer (5),
a separate tap changer (20) is provided for each phase of the transformer (5) which is configured to change a transmission ratio of the transformer (5),
the device (30) is configured to simultaneously generate respectively one test signal for each phase of the transformer (5) by means of the test signal generation means (31) and to supply said test signal to a winding (1-3) of the transformer (5) assigned to the respective phase and to the tap changer (20) assigned to the winding (1-3),
the device (30) is configured to determine a curve of an electrical measurement variable (I₁; I₂) of the transformer (5) by means of the measuring means (9) over time (t) respectively during an actuation of the tap changers (20) for each tap changer (20) depending on the test signal, and
the control means (7) are configured to illustrate the curves (41, 42) of the respective tap changer (20) for each tap changer (20) in a temporally-superimposed manner.

11. Device according to claim 9 or 10,
**characterised in that**
the device (30) comprises a display (8),
the device (30) is configured such that the control means (7) illustrate the curves (41, 42) on the display (8).

12. Device according to any one of claims 9-11,
**characterised in that**
the device (30) is configured to perform the method according to any one of claims 1-8.

## Revendications

1. Procédé destiné à contrôler un commutateur à gradins (20) d'un transformateur (5; 6),
dans lequel le commutateur à gradins (20) est conçu pour modifier un rapport de transformation du transformateur (5; 6),
dans lequel le procédé comprend les étapes suivantes :
génération d'un signal d'essai, lequel est amené à un enroulement (1-3; 10) du transformateur (5; 6) et au commutateur à gradins (20),
actionnement multiple du commutateur à gradins (20) pour modifier le rapport de transformation à chaque actionnement,
saisie d'un tracé d'une grandeur de mesure électrique (I; I₁; I₂) du transformateur (5; 6) dans le temps (t) respectivement pendant l'étape d'actionnement du commutateur à gradins (20) en fonction du signal d'essai, et représentation automatique superposée dans le temps des tracés (41, 42) de la grandeur de mesure électrique (I; I₁; I₂) saisis pendant l'actionnement multiple du commutateur à gradins (20).

2. Procédé selon la revendication 1,
**caractérisé en ce que**
le transformateur est un transformateur (5) polyphasé,
pour chaque phase du transformateur (5), un commutateur à gradins (20) séparé est disponible, lequel est conçu pour modifier un rapport de transformation du transformateur (5),
un signal d'essai est généré respectivement simultanément pour chaque phase du transformateur (5), lequel est amené à un enroulement (1-3) du transformateur (5) attribué à la phase respective et au commutateur à gradins (20) attribué à l'enroulement (1-3),
les commutateurs à gradins (20) sont actionnés à de multiples reprises pour modifier le rapport de transformation à chaque actionnement,
un tracé d'une grandeur de mesure électrique (I₁; I₂) du transformateur (5) dans le temps (t) est saisi respectivement pendant l'étape d'actionnement des commutateurs à gradins (20) pour chaque commutateur à gradins (20) en fonction du signal d'essai, et
les tracés (41, 42) du commutateur à gradins (20) respectif sont représentés automatiquement superposés dans le temps.

3. Procédé selon la revendication 2,
**caractérisé en ce que**
les signaux d'essai pour chaque phase sont produits de manière identique en termes de montant.

4. Procédé selon l'une quelconque des revendications précédentes,
**caractérisé en ce que**
le signal d'essai est un signal à courant continu.

5. Procédé selon l'une quelconque des revendications précédentes,
**caractérisé en ce que**
les tracés (41, 42) sont appliqués avec une couverture aussi identique que possible.

6. Procédé selon l'une quelconque des revendications 1 à 4,
**caractérisé en ce que**
les tracés sont appliqués de manière décalée.

7. Procédé selon l'une quelconque des revendications précédentes,
**caractérisé en ce que**
des périodes de temps correspondant l'une à l'autre (t₀-t₁) des tracés (41, 42) sont représentées superposées dans le temps.

8. Procédé selon l'une quelconque des revendications précédentes,
**caractérisé en ce que**
la grandeur de mesure électrique
comprend un courant (I; I₁; I₂), lequel circule à travers l'enroulement (1-3; 10) et le commutateur à gradins (20),
une tension, laquelle diminue au niveau de l'enroulement (1-3; 10), ou
une valeur de résistance électrique, laquelle peut être calculée en fonction de la tension et du courant (I; I₁; I₂).

9. Dispositif destiné à contrôler un commutateur à gradins (20) d'un transformateur (5; 6),
dans lequel le commutateur à gradins (20) est configuré pour modifier un rapport de transformation du transformateur (5; 6),
dans lequel le dispositif (30) comprend des moyens de génération de signal d'essai (31), des moyens de mesure (9) et des moyens de commande (7),
dans lequel le dispositif (30) est conçu pour amener un signal d'essai à un enroulement (10) du transformateur (5; 6) et au commutateur à gradins (20) à l'aide des moyens de génération de signal d'essai (31) et des moyens de commande (7),
dans lequel le dispositif (30) est conçu pour saisir, à l'aide des moyens de mesure (9), un tracé d'une grandeur de mesure électrique (I; I₁; I₂) du transformateur (5; 6) dans le temps (t) respectivement pendant un actionnement du commutateur à gradins (20) en fonction du signal d'essai, et
dans lequel les moyens de commande (7) sont conçus pour représenter les tracés (41, 42) des grandeurs de mesure électriques (I; I₁; I₂) saisis pendant l'actionnement multiple du commutateur à gradins (20) de manière superposée dans le temps.

10. Dispositif selon la revendication 9,
**caractérisé en ce que**
le transformateur est un transformateur (5) polyphasé,
pour chaque phase du transformateur (5), un commutateur à gradins (20) séparé est disponible, lequel est conçu pour modifier un rapport de transformation du transformateur (5),
le dispositif (30) est conçu pour générer respectivement simultanément un signal d'essai pour chaque phase du transformateur (5) à l'aide des moyens de génération de signal d'essai (31) et pour l'amener à un enroulement (1-3) du transformateur (5) attribué à la phase respective et au commutateur à gradins (20) attribué à l'enroulement (1-3),
le dispositif (30) est conçu pour saisir, à l'aide des moyens de mesure (9), un tracé d'une grandeur de mesure électrique (I₁; I₂) du transformateur (5) dans le temps (t) respectivement pendant un actionnement des commutateurs à gradins (20) pour chaque commutateur à gradins (20) en fonction du signal d'essai, et
les moyens de commande (7) sont conçus pour représenter, pour chaque commutateur à gradins (20), les tracés (41, 42) du commutateur à gradins (20) respectif de manière superposée dans le temps.

11. Dispositif selon la revendication 9 ou 10,
**caractérisé en ce que**
le dispositif (30) comprend une indication (8),
le dispositif (30) est conçu de sorte que les moyens de commande (7) représentent les tracés (41, 42) sur l'afficheur (8).

12. Dispositif selon l'une quelconque des revendications 9 à 11,
**caractérisé en ce que**
le dispositif (30) destiné à la réalisation du procédé est conçu selon l'une quelconque des revendications 1 à 8.
